(19)

Europäisches Patentamt

European Patent Office

Office européen des brevets

(11) **EP 4 282 610 A1**

(12) **EUROPEAN PATENT APPLICATION**
published in accordance with Art. 153(4) EPC

(43) Date of publication:
**29.11.2023 Bulletin 2023/48**

(21) Application number: **22742719.2**

(22) Date of filing: **25.01.2022**

(51) International Patent Classification (IPC):
**B29B 15/10** (2006.01)  **B29C 45/00** (2006.01)
**B29K 101/12** (2006.01)  **B29K 105/14** (2006.01)
**C08J 3/20** (2006.01)  **C08K 7/02** (2006.01)
**C08K 7/04** (2006.01)  **C08L 23/00** (2006.01)
**C08L 77/00** (2006.01)  **C08L 101/00** (2006.01)
**C08J 5/00** (2006.01)  **B29C 70/06** (2006.01)
**B29C 70/42** (2006.01)  **C08K 3/013** (2018.01)
**C08K 3/04** (2006.01)

(52) Cooperative Patent Classification (CPC):
**B29B 15/10; B29C 45/00; B29C 70/06;**
**B29C 70/42; C08J 3/20; C08J 5/00; C08K 3/013;**
**C08K 3/04; C08K 7/02; C08K 7/04; C08L 23/00;**
**C08L 77/00; C08L 101/00;** B29K 2101/12;
B29K 2105/14

(86) International application number:
**PCT/JP2022/002550**

(87) International publication number:
**WO 2022/158600 (28.07.2022 Gazette 2022/30)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **25.01.2021 JP 2021009386**
**25.01.2021 JP 2021009387**
**23.06.2021 JP 2021104364**

(71) Applicant: Sekisui Techno Molding Co., Ltd.
**Minato-ku, Tokyo 105-8566 (JP)**

(72) Inventors:
• **MASUDA, Takuya**
**Toyohashi-shi, Aichi 441-8123 (JP)**
• **SUENAGA, Yuusuke**
**Toyohashi-shi, Aichi 441-8123 (JP)**
• **MATSUMURA, Ryuuji**
**Toyohashi-shi, Aichi 441-8123 (JP)**
• **HIGUCHI, Isao**
**Mishima-gun, Osaka 618-0021 (JP)**
• **SHINOHARA, Takamichi**
**Mishima-gun, Osaka 618-0021 (JP)**

(74) Representative: **Ter Meer Steinmeister & Partner
Patentanwälte mbB
Nymphenburger Straße 4
80335 München (DE)**

(54) **RESIN COMPOSITION AND RESIN MOLDED ARTICLE**

(57) Provided is a resin composition with which a resin molded article having excellent heat dissipation can be obtained. A resin composition containing: a thermoplastic resin; graphite; and a fibrous body, when the resin composition in a molten state is filled in a mold from a direction orthogonal to a thickness direction of a resulting resin molded article 1 and molded to obtain a resin molded article 1 of 100 mm in length × 100 mm in width × 2 mm in thickness, in a cross-section obtained by cutting the resin molded article 1 along a direction X parallel to a filling direction and a thickness direction Z, among regions 1A to 1E obtained by dividing the cross-section into five equal parts in the thickness direction Z, an average orientation angle (A) with respect to a plane direction of the graphite in at least one of the regions 1A and 1E on outermost layer sides being 15° or less, and an average orientation angle (B) with respect to the plane direction of the graphite in the central region 1C being 35° or more.

EP 4 282 610 A1

**Description**

**TECHNICAL FIELD**

The present invention relates to a resin composition and a resin molded article using the resin composition.

**BACKGROUND ART**

Conventionally, a metal plate, a resin molded article having thermal conductivity, or the like is used for a casing of a communication device or an electronic device, such as a security camera or a smart meter, used indoors or outdoors, a heat dissipation chassis of multi-information display, such as a car navigation system or a smart meter, or an in-vehicle camera, an LED heat dissipation heat sink, or a heat dissipation plate of SoC, GDC, or the like. SoC refers to "System-on-a-chip" and GDC refers to "Graphics Display Controller".

Patent Document 1 below describes a resin composite molded article containing a thermoplastic resin and a filler dispersed in the thermoplastic resin and made of a carbon material having a graphene structure. In Patent Document 1, a relationship between an angle formed by an average direction in longitudinal directions of all the fillers and the longitudinal direction of the filler and a proportion of the fillers satisfying the angle is located in a region A (when the proportion is designated as "y" and the angle is designated as "x", $y \geq 6.67x$) shown in Fig. 1 of Patent Document 1.

Patent Document 2 below discloses a resin multilayer molded article containing a thermoplastic resin and a filler made of a carbon material having a graphene structure. In Patent Document 2, the resin multilayer molded article is formed by laminating a plurality of resin composition layers in which the filler is dispersed in the thermoplastic resin, and an angle formed by a longitudinal direction of each of the fillers and an average direction of the longitudinal directions of all the fillers is $\pm 6°$ or less.

**Related Art Document**

**Patent Document**

Patent Document 1: JP 2012-082382 A
Patent Document 2: JP 2014-000789 A

**SUMMARY OF THE INVENTION**

**PROBLEMS TO BE SOLVED BY THE INVENTION**

In recent years, with an increase in speed of a CPU, a resin molded article having higher heat dissipation than before is required. However, in the resin molded articles as in Patent Document 1 and Patent Document 2, there is a problem in that the heat dissipation in a plane direction is still insufficient particularly when the thickness increases.

An object of the present invention is to provide a resin composition with which a resin molded article having excellent heat dissipation can be obtained and a resin molded article using the resin composition.

**MEANS FOR SOLVING THE PROBLEMS**

A resin composition according to a first invention of the present application contains: a thermoplastic resin; graphite; and a fibrous body, when the resin composition in a molten state is filled in a mold from a direction orthogonal to a thickness direction of a resulting resin molded article and molded to obtain a resin molded article of 100 mm in length × 100 mm in width × 2 mm in thickness, in a cross-section obtained by cutting the resin molded article along a direction parallel to a filling direction and the thickness direction, among regions obtained by dividing the cross-section into five equal parts in the thickness direction, an average orientation angle (A) with respect to a plane direction of the graphite in at least one of the regions on outermost layer sides being 15° or less, and an average orientation angle (B) with respect to the plane direction of the graphite in the central region being 35° or more.

A resin composition according to a second invention of the present application contains: a thermoplastic resin; graphite; and a fibrous body, when the resin composition in a molten state is filled in a mold from a direction orthogonal to a thickness direction of a resulting resin molded article and molded to obtain a resin molded article of 100 mm in length × 100 mm in width × 2 mm in thickness, in a cross-section obtained by cutting the resin molded article along a direction orthogonal to a filling direction and the thickness direction, among regions obtained by dividing the cross-section into five equal parts in the thickness direction, an average orientation angle (A) with respect to a plane direction of the graphite in at least one of the regions on outermost layer sides being 10° or less, and an average orientation angle (B) with respect to the plane direction of the graphite in the central region being 15° or more.

A resin composition according to a third invention of the present application contains: a thermoplastic resin; graphite; and a fibrous body, when the resin composition in a molten state is filled in a mold from a direction orthogonal to a thickness direction of a resulting resin molded article and molded to obtain a resin molded article of 100 mm in length × 100 mm in width × 2 mm in thickness, in a cross-section obtained by cutting the resin molded article along a direction parallel to a filling direction and the thickness direction, among regions obtained by dividing the cross-section into five equal parts in the thickness direction, a ratio (average orientation angle (B)/average orientation angle (A)) of an average orientation angle (B) with respect to a plane direction of the graphite in the central region to an average orientation angle (A) with respect to the plane direction of the graphite in at least one of the regions on outermost layer sides being 3.5 or more.

A resin composition according to a fourth invention of the present application contains: a thermoplastic resin; graphite; and a fibrous body, when the resin composition in a molten state is filled in a mold from a direction orthogonal to a thickness direction of a resulting resin molded article and molded to obtain a resin molded article of 100 mm in length × 100 mm in width × 2 mm in thickness, in a cross-section obtained by cutting the resin molded article along a direction orthogonal to a filling direction and the thickness direction, among regions obtained by dividing the cross-section into five equal parts in the thickness direction, a ratio (average orientation angle (B)/average orientation angle (A)) of an average orientation angle (B) with respect to a plane direction of the graphite in the central region to an average orientation angle (A) with respect to the plane direction of the graphite in at least one of the regions on outermost layer sides being 2 or more.

A resin composition according to a fifth invention of the present application contains: a thermoplastic resin; graphite; and a fibrous body, when the resin composition in a molten state is filled in a mold from a direction orthogonal to a thickness direction of a resulting resin molded article and molded to obtain a resin molded article of 100 mm in length × 100 mm in width × 2 mm in thickness, a ratio M/N being 0.30 or more, where a peak intensity ratio (D/G ratio) between a D band and a G band obtained when a surface layer portion of the resin molded article is subjected to Raman spectroscopic analysis is designated as "M", and a peak intensity ratio (D/G ratio) between a D band and a G band obtained when a cross-sectional center portion of a cross-section obtained by cutting the resin molded article along the thickness direction is subjected to Raman spectroscopic analysis is designated as "N".

Hereinafter, the first to fifth inventions of the present application may be collectively referred to as the present invention.

In a specific aspect of the resin composition according to the present invention, the graphite is plate-like graphite.

In another specific aspect of the resin composition according to the present invention, the fibrous body is at least one selected from the group consisting of glass fibers, carbon fibers, and resin fibers.

In still another specific aspect of the resin composition according to the present invention, the resin composition further contains carbon black.

In still another specific aspect of the resin composition according to the present invention, the thermoplastic resin includes an olefin-based resin.

In still another specific aspect of the resin composition according to the present invention, when the resin composition in a molten state is filled in a mold from a direction orthogonal to a thickness direction of a resulting resin molded article and molded to obtain a resin molded article of 100 mm in length × 100 mm in width × 2 mm in thickness, a thermal conductivity in an in-plane direction of a main surface of the resin molded article is 2 W/(m·K) or more.

A resin molded article according to the present invention is a molded article of the resin composition configured according to the present invention.

**EFFECT OF THE INVENTION**

According to the present invention, it is possible to provide a resin composition with which a resin molded article having excellent heat dissipation can be obtained and a resin molded article using the resin composition.

**BRIEF DESCRIPTION OF DRAWINGS**

[Fig. 1] Fig. 1(a) is a schematic plan view illustrating an example of a resin molded article obtained by molding a resin composition according to an embodiment of the present invention, and Fig. 1(b) is a schematic cross-sectional view taken along line A-A in Fig. 1(a).
[Fig. 2] Fig. 2 is a schematic cross-sectional view taken along line B-B in Fig. 1(a).

[Fig. 3] Fig. 3 is a schematic perspective view illustrating a heat dissipation chassis.

[Fig. 4] Fig. 4 is a schematic perspective view illustrating a heat dissipation casing.

[Fig. 5] Fig. 5 is a schematic perspective view illustrating a heat sink shape.

[Fig. 6] Fig. 6 is a cross-sectional photograph of a resin molded article obtained in Example 1.

[Fig. 7] Fig. 7 is a view showing an average orientation angle of each region in a cross-section of the resin molded article obtained in Example 1.

[Fig. 8] Fig. 8 is a view showing an average orientation angle of each region in a cross-section of a resin molded article obtained in Comparative Example 1.

## MODES FOR CARRYING OUT THE INVENTION

Hereinafter, the present invention will be clarified by describing specific embodiments of the present invention with reference to the drawings.

[Resin composition]

A resin composition according to the present invention contains a thermoplastic resin, graphite, and a fibrous body.

In the resin composition according to the first invention of the present application, when a resin molded article under the following condition (1) is obtained, in a cross-section obtained by cutting the resin molded article along a direction parallel to a filling direction and the thickness direction, among regions obtained by dividing the cross-section into five equal parts in the thickness direction, an average orientation angle (A) with respect to a plane direction of the graphite in at least one of the regions on outermost layer sides is 15° or less. An average orientation angle (B) with respect to the plane direction of the graphite in the central region is 35° or more.

Condition (1): The resin composition in a molten state is filled in a mold from a direction orthogonal to a thickness direction of a resulting resin molded article and molded to obtain a resin molded article of 100 mm in length $\times$ 100 mm in width $\times$ 2 mm in thickness.

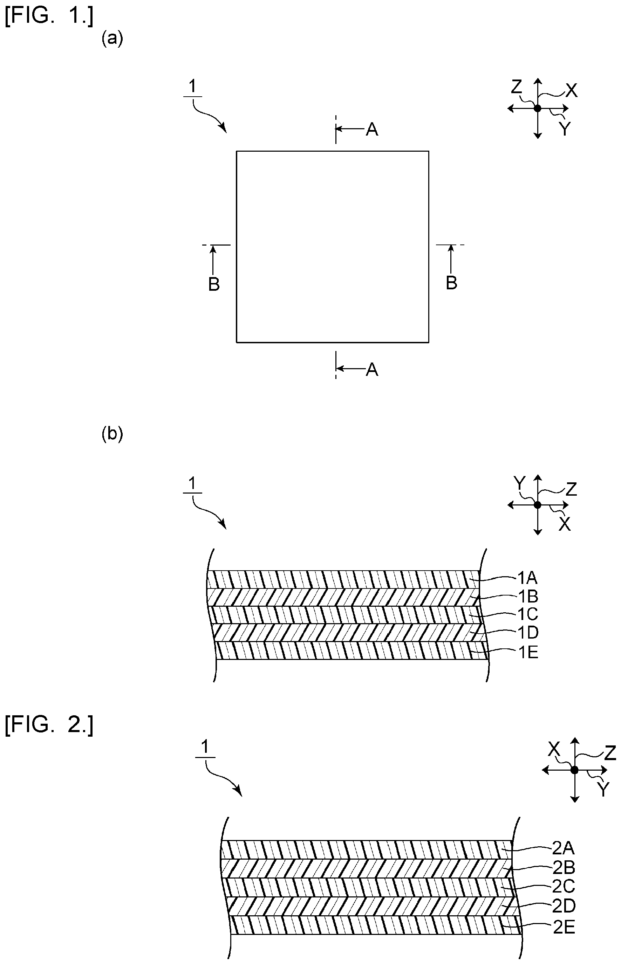

Hereinafter, an example of the resin composition in the first invention will be described in more detail with reference to Figs. 1(a) and 1(b).

Fig. 1(a) is a schematic plan view illustrating an example of a resin molded article obtained by molding a resin composition according to an embodiment of the present invention. Fig. 1(b) is a schematic cross-sectional view of the resin molded article in Fig. 1(a) taken along line A-A.

A resin molded article 1 illustrated in Figs. 1(a) and 1(b) is a resin molded article obtained according to the above-described condition (1).

In the first invention, when an X direction illustrated in Fig. 1(a) is a filling direction in which the resin composition in a molten state is filled from a gate, a cross-section of the resin molded article 1 cut along the X direction parallel to the filling direction is obtained. More specifically, as illustrated in Fig. 1(b), a cross-section of the resin molded article 1 cut along the X direction parallel to the filling direction and a Z direction, which is the thickness direction, is obtained.

In the cross-sectional view of Fig. 1(b) obtained as described above, the cross-section is divided into five equal parts in the thickness direction to obtain regions 1A to 1E. At this time, the regions 1A and 1E are the regions on outermost layer sides and the region 1C is the central region. In the present embodiment, each of the average orientation angles (A) with respect to the plane direction of the graphite in the regions 1A and 1E on outermost layer sides is 15° or less, and the average orientation angle (B) with respect to the plane direction of the graphite in the central region 1C is 35° or more. In the cross-sectional view of Fig. 1(b), the X direction is the plane direction, and an orientation angle indicates how many degrees the graphite is inclined in the Z direction, which is the thickness direction, with respect to the X direction, which is the plane direction.

When the average orientation angle (A) and the average orientation angle (B) are determined, a cross-section of the resin molded article 1 can be obtained by, for example, treating with an ultrasonic cutting device or a cross section polisher (CP). The obtained cross-section can be observed using a microscope or a scanning electron microscope (SEM). The average orientation angle (A) and the average orientation angle (B) can be obtained by analyzing a photograph obtained with a microscope or a scanning electron microscope using image analysis software. As the image analysis software, for example, as described in Examples described below, OrientationJ that is a plug-in for image analysis software ImageJ can be used. Specifically, the average orientation angle (A) and the average orientation angle (B) can be obtained by analyzing the arrangement state by Rezakhaniha et al, 2012, Biomechanics and modeling in mechanobiology, 11: 461-73.

According to such a resin composition of the first invention, a resin molded article having excellent heat dissipation can be obtained.

Conventionally, in a resin molded article obtained by molding a resin composition containing graphite, thermal conductivity in the plane direction has been enhanced by orienting the graphite in a sheet stretching direction. However, this method has a problem in that the heat dissipation is not sufficiently enhanced when the thickness of the resin molded article is increased.

On the other hand, in the resin molded article obtained by molding the resin composition of the first invention, among the regions obtained by dividing the cross-section into five equal parts in the thickness direction, the average orientation angle (A) with respect to the plane direction of the graphite in at least one of the regions on outermost layer sides is 15° or less, and the graphite is more oriented in the plane direction in the region on the outermost layer sides. Among the regions obtained by dividing the cross-section into five equal parts in the thickness direction, the average orientation angle (B) with respect to the plane direction of the graphite in the central region is 35° or more, and the graphite is oriented also toward the thickness direction side in the central region. Therefore, a heat conduction path is formed not only in the plane direction but also in the thickness direction, and particularly even in a resin molded article having a large thickness, the heat dissipation in the plane direction can be enhanced in the entire resin molded article.

In the first invention, among the regions obtained by dividing the cross-section into five equal parts in the thickness direction, the average orientation angle (A) with respect to the plane direction of the graphite in one of the regions on outermost layer sides may be 15° or less, but each of the average orientation angles (A) with respect to the plane direction of the graphite in both the regions on the outermost layer sides is preferably 15° or less. In this case, the heat dissipation in the plane direction of the entire resin molded article can be further enhanced.

In the first invention, among the regions obtained by dividing the cross-section into five equal parts in the thickness direction, the average orientation angle (A) with respect to the plane direction of the graphite in at least one of the regions on outermost layer sides is preferably 12° or less and more preferably 10° or less. In this case, the heat dissipation in the plane direction of the entire resin molded article can be further enhanced. The lower limit value of the average orientation angle (A) is not particularly limited, and can be, for example, 5°.

In the first invention, among the regions obtained by dividing the cross-section into five equal parts in the thickness direction, the average orientation angle (B) with respect to the plane direction of the graphite in the central region is 35° or more and preferably 37° or more. In this case, the heat dissipation in the plane direction of the entire resin molded article can be further enhanced. The upper limit value of the average orientation angle (B) is not particularly limited, and can be, for example, 60° and is preferably 50° or less.

In the resin composition according to the second invention of the present application, when a resin molded article under the above-described condition (1) is obtained, in a cross-section obtained by cutting the resin molded article along a direction orthogonal to a filling direction and the thickness direction, among regions obtained by dividing the cross-section into five equal parts in the thickness direction, an average orientation angle (A) with respect to a plane direction of the graphite in at least one of the regions on outermost layer sides is 10° or less. An average orientation angle (B) with respect to the plane direction of the graphite in the central region is 15° or more.

In the second invention, for example, when an X direction illustrated in Fig. 1(a) is a filling direction in which the resin composition in a molten state is filled from a gate, a cross-section of the resin molded article 1 cut along the Y direction orthogonal to the X direction is obtained. More specifically, as illustrated in Fig. 2, a cross-section of the resin molded article 1 cut along the Y direction orthogonal to the X direction and the Z direction, which is the thickness direction, is obtained. In the cross-section thus obtained, among regions 2A to 2E obtained by dividing the cross-section into five equal parts in the thickness direction, the average orientation angle (A) with respect to the plane direction of the graphite in at least one of the regions 2A and 2E on outermost layer sides is 10° or less, and the average orientation angle (B) with respect to the plane direction of the graphite in the central region 2C is 15° or more. The average orientation angle (A) and the average orientation angle (B) can be determined by the same method as in the first invention. In the cross-sectional view of Fig. 2, the Y direction is the plane direction, and an orientation angle indicates how many degrees the graphite is inclined in the Z direction, which is the thickness direction, with respect to the Y direction, which is the plane direction.

According to such a resin composition of the second invention, a resin molded article having excellent heat dissipation can be obtained.

Specifically, in the resin molded article obtained by molding the resin composition of the second invention, among the regions obtained by dividing the cross-section into five equal parts in the thickness direction, the average orientation angle (A) with respect to the plane direction of the graphite in at least one of the regions on outermost layer sides is 10° or less, and the graphite is more oriented in the plane direction in the region on the outermost layer side. Among the regions obtained by dividing the cross-section into five equal parts in the thickness direction, the average orientation angle (B) with respect to the plane direction of the graphite in the central region is 15° or more, and the graphite is oriented also toward the thickness direction side in the central region. Therefore, a heat conduction path is formed not only in the plane direction but also in the thickness direction, and particularly even in a resin molded article having a large thickness, the heat dissipation in the plane direction can be enhanced in the entire resin molded article.

In the second invention, among the regions obtained by dividing the cross-section into five equal parts in the thickness direction, the average orientation angle (A) with respect to the plane direction of the graphite in one of the regions on outermost layer sides may be 10° or less, but the average orientation angles (A) with respect to the plane direction of the graphite in both the regions on the outermost layer sides are preferably 10° or less. In this case, the heat dissipation in the plane direction of the entire resin molded article can be further enhanced.

In the second invention, among the regions obtained by dividing the cross-section into five equal parts in the thickness direction, the average orientation angle (A) with respect to the plane direction of the graphite in at least one of the regions on outermost layer sides is 10° or less and preferably 8° or less. In this case, the heat dissipation in the plane direction of the entire resin molded article can be further enhanced. The lower limit value of the average orientation angle (A) is not particularly limited, and can be, for example, 3°.

In the second invention, among the regions obtained by dividing the cross-section into five equal parts in the thickness direction, the average orientation angle (B) with respect to the plane direction of the graphite in the central region is 15° or more and preferably 18° or more. In this case, the heat dissipation in the plane direction of the entire resin molded article can be further enhanced. The upper limit value of the average orientation angle (B) is not particularly limited, and can be, for example, 60° and is preferably 50° or less, more preferably 40° or less, and further preferably 30° or less.

In the resin composition according to the third invention of the present application, when a resin molded article under the above-described condition (1) is obtained, in a cross-section obtained by cutting the resin molded article along a direction parallel to a filling direction and the thickness direction in the same manner as in the first invention, a ratio (average orientation angle (B)/average orientation angle (A)) of an average orientation angle (B) to an average orientation angle (A) is 3.5 or more. Among the regions obtained by dividing the cross-section into five equal parts in the thickness direction, the average orientation angle (A) is an average orientation angle with respect to the plane direction of the graphite in at least one of the regions on outermost layer sides. Among the regions obtained by dividing the cross-section into five equal parts in the thickness direction, the average orientation angle (B) is an average orientation angle with respect to the plane direction of the graphite in the central region.

In the third invention, when an X direction illustrated in Fig. 1(a) is a filling direction in which the resin composition in a molten state is filled from a gate, a cross-section of the resin molded article 1 cut along the X direction parallel to the filling direction is obtained. More specifically, as illustrated in Fig. 1(b), a cross-section of the resin molded article 1 cut along the X direction parallel to the filling direction and a Z direction, which is the thickness direction, is obtained. In the cross-section thus obtained, among the regions 1A to 1E obtained by dividing the cross-section into five equal parts in the thickness direction, the ratio (average orientation angle (B)/average orientation angle (A)) of the average orientation angle (B) with respect to the plane direction of the graphite in the central region 1C to the average orientation angle (A) with respect to the plane direction of the graphite in at least one of the regions 1A and 1E on outermost layer sides is 3.5 or more. The average orientation angle (A) and the average orientation angle (B) can be determined by the same method as in the first invention.

According to the resin composition of the third invention, a resin molded article having excellent heat dissipation can be obtained.

In the resin molded article obtained by molding the resin composition of the third invention, since the ratio (average orientation angle (B)/average orientation angle (A)) is 3.5 or more, the graphite can be oriented also toward the thickness direction side in the central region while the graphite is oriented in the plane direction in the region on the outermost layer side. Therefore, a heat conduction path is formed not only in the plane direction but also in the thickness direction, and particularly even in a resin molded article having a large thickness, the heat dissipation in the plane direction can be enhanced in the entire resin molded article.

In the third invention, the average orientation angle (A) with respect to the plane direction of the graphite in one of the regions on outermost layer sides may satisfy the ratio (average orientation angle (B)/average orientation angle (A)). In particular, each of the average orientation angles (A) with respect to the plane direction of the graphite in both the regions on the outermost layer sides preferably satisfies the ratio (average orientation angle (B)/average orientation angle (A)). In this case, the heat dissipation in the plane direction of the entire resin molded article can be further enhanced.

In the third invention, the ratio (average orientation angle (B)/average orientation angle (A)) is 3.5 or more and preferably 3.7 or more. In this case, the heat dissipation in the plane direction of the entire resin molded article can be further enhanced. The upper limit value of the ratio (average orientation angle (B)/average orientation angle (A)) is not particularly limited, and can be, for example, 7.0 and is preferably 6.0 or less and more preferably 5.0 or less.

In the resin composition according to the fourth invention of the present application, when a resin molded article under the above-described condition (1) is obtained, in a cross-section obtained by cutting the resin molded article along a direction orthogonal to a filling direction and the thickness direction in the same manner as in the second invention, a ratio (average orientation angle (B)/average orientation angle (A)) of an average orientation angle (B) to an average orientation angle (A) is 2.0 or more. Among the regions obtained by dividing the cross-section into five equal parts in the thickness direction, the average orientation angle (A) is an average orientation angle with respect to the plane direction of the graphite in at least one of the regions on outermost layer sides. Among the regions obtained by dividing the cross-section into five equal parts in the thickness direction, the average orientation angle (B) is an average orientation angle with respect to the plane direction of the graphite in the central region.

In the fourth invention, for example, when an X direction illustrated in Fig. 1(a) is a filling direction in which the resin composition in a molten state is filled from a gate, a cross-section of the resin molded article 1 cut along the Y direction orthogonal to the X direction is obtained. More specifically, as illustrated in Fig. 2, a cross-section of the resin molded article 1 cut along the Y direction orthogonal to the X direction and the Z direction, which is the thickness direction, is obtained. In the cross-section thus obtained, among the regions 2A to 2E obtained by dividing the cross-section into five equal parts in the thickness direction, the ratio (average orientation angle (B)/average orientation angle (A)) of the average orientation angle (B) with respect to the plane direction of the graphite in the central region 2C to the average orientation angle (A) with respect to the plane direction of the graphite in at least one of the regions 2A and 2E on outermost layer sides is 2.0 or more. The average orientation angle (A) and the average orientation angle (B) can be determined by the same method as in the first invention.

According to the resin composition of the fourth invention, a resin molded article having excellent heat dissipation can be obtained.

In the resin molded article obtained by molding the resin composition of the fourth invention, since the ratio (average orientation angle (B)/average orientation angle (A)) is 2.0 or more, the graphite can be oriented also toward the thickness direction side in the central region while the graphite is oriented in the plane direction in the region on the outermost layer side. Therefore, a heat conduction path is formed not only in the plane direction but also in the thickness direction, and particularly even in a resin molded article having a large thickness, the heat dissipation in the plane direction can be enhanced in the entire resin molded article.

In the fourth invention, the average orientation angle (A) with respect to the plane direction of the graphite in one of the regions on outermost layer sides may satisfy the ratio (average orientation angle (B)/average orientation angle (A)). Each of the average orientation angles (A) with respect to the plane direction of the graphite in both the regions on the outermost layer sides preferably satisfies the ratio (average orientation angle (B)/average orientation angle (A)). In this case, the heat dissipation in the plane direction of the entire resin molded article can be further enhanced.

In the fourth invention, the ratio (average orientation angle (B)/average orientation angle (A)) is 2.0 or more and preferably 2.2 or more. In this case, the heat dissipation in the plane direction of the entire resin molded article can be further enhanced. The upper limit value of the ratio (average orientation angle (B)/average orientation angle (A)) is not particularly limited, and can be, for example, 6.0 and is preferably 5.0 or less and more preferably 4.0 or less.

In the resin composition according to the fifth invention of the present application, when a resin molded article under the above-described condition (1) is obtained, a ratio M/N is 0.30 or more, where a D/G ratio of a surface layer portion of the resin molded article is designated as "M", and a D/G ratio of a cross-sectional center portion of a cross-section obtained by cutting the resin molded article along the thickness direction is designated as "N".

In the fifth invention, for example, an XY plane of the resin molded article 1 in Fig. 1(a) is defined as the surface layer portion. When an X direction illustrated in Fig. 1(a) is a filling direction in which the resin composition in a molten state is filled from a gate, a cross-section of the resin molded article 1 cut along the X direction parallel to the filling direction is obtained. More specifically, as illustrated in Fig. 1(b), a cross-section of the resin molded article 1 cut along the X direction parallel to the filling direction and a Z direction, which is the thickness direction, is obtained. In the fifth invention, when an X direction illustrated in Fig. 1(a) is a filling direction in which the resin composition in a molten state is filled from a gate, a cross-section of the resin molded article 1 cut along the Y direction orthogonal to the X direction is obtained. More specifically, as illustrated in Fig. 2, a cross-section of the resin molded article 1 cut along the Y direction orthogonal to the X direction and the Z direction, which is the thickness direction, is obtained. Portions corresponding to regions other than the surface layer portion among regions obtained by dividing the cross-section of the resin molded article 1 into five equal parts, that is, the regions 1B, 1C, and 1D in Fig. 1(b) and the regions 2B, 2C, and 2D in Fig. 2 are defined as the cross-sectional center portions.

In the fifth invention, the D/G ratio is a peak intensity ratio between the D band and G band in a Raman spectrum obtained by Raman spectroscopic analysis.

The D band in the Raman spectrum is a peak derived from a defect structure. In the carbon material, the D band is usually observed around 1,300 cm$^{-1}$ to 1,400 cm$^{-1}$ of the Raman spectrum.

On the other hand, the G band in the Raman spectrum is a peak derived from in-plane stretching vibration of a 6-membered ring structure of the carbon atom. In the carbon material, the G band is usually observed around 1,550 cm$^{-1}$ to 1,620 cm$^{-1}$ of the Raman spectrum.

The Raman spectroscopic analysis can be performed using, for example, a Raman spectrometer (trade name "inVia Qontor" manufactured by Renishaw plc). Preferable measurement conditions are as follows.

<Measurement conditions>

Objective lens: magnification 50 times
Excitation laser wavelength: 532 nm
Laser power: 0.5%
Irradiation time: 5 seconds
Diffraction grating: 1,800 lines/mm
Measurement wavenumber: 605cm$^{-1}$ to 2281cm$^{-1}$

The peak intensity ratio (D/G ratio) M of the surface layer portion of the resin molded article can be determined, for example, as follows. First, a Raman spectrum is measured at 100 or more points on a surface (for example, the XY plane in Fig. 1(a)), and baseline correction, removal of an abnormal spectrum, and normalization of a Y axis (Raman intensity) are performed for each obtained spectrum. Next, the obtained average spectrum is subjected to peak separation treatment, and the intensity ratio D/G ratio of peaks corresponding to the D band and the G band is calculated. The measurement is performed on the front surface and the back surface, and the average value is defined as "M".

The peak intensity ratio (D/G ratio) N of the cross-sectional center portion of the resin molded article can be determined, for example, as follows. First, a Raman spectrum is measured at 100 or more points for the regions 1B, 1C, and 1D on a XZ plane in Fig. 1(a), and baseline correction, removal of an abnormal spectrum, and normalization of a Y axis (Raman intensity) are performed for each obtained spectrum. Next, the obtained average spectrum is subjected to peak separation treatment, and the D/G ratio of the intensity ratio of peaks corresponding to the D band and the G band is calculated. The measurement is similarly performed on the regions 2B, 2C, and 2D on a YZ plane in Fig. 2, and the average value of the XZ plane and the YZ plane is defined as "N".

According to the resin composition of the fifth invention, a resin molded article having excellent heat dissipation can be obtained.

In the resin molded article obtained by molding the resin composition of the fifth invention, since the ratio M/N is 0.3 or more, where the D/G ratio of the surface layer portion is defined as "M" and the D/G ratio of the cross-sectional center portion is defined as "N", the content of the graphite in the region on a surface layer side can be increased, and the graphite can be unevenly distributed. Therefore, a favorable heat conduction path is formed in the plane direction, and even in a resin molded article having a large thickness, the heat dissipation in the plane direction can be enhanced.

In the fifth invention, the ratio M/N ((D/G ratio of surface layer portion)/(D/G ratio of cross-sectional center portion)) is 0.30 or more, preferably 0.50 or more, and more preferably 0.70 or more. In this case, the heat dissipation in the plane direction of the resin molded article can be further enhanced. The upper limit value of the ratio M/N ((D/G ratio of surface layer portion)/(D/G ratio of cross-sectional center portion)) is not particularly limited, and can be, for example, 5.0 and is preferably 4.0 or less, more preferably 3.0 or less, further preferably 2.0 or less, and particularly preferably 1.5 or less.

Each of the first to fifth inventions of the present application may be used alone, or at least two or more inventions may be used in combination. Hereinafter, the first to fifth inventions of the present application may be collectively referred to as the present invention.

A resin composition of the present invention contains a thermoplastic resin, graphite, and a fibrous body. The resin composition may contain other materials such as the carbon black and other additives as necessary. In particular, in the fifth invention, the resin composition preferably contains carbon black. In this case, carbon black can be attached to graphite unevenly distributed in the region on the surface layer side, and carbon black can also be unevenly distributed in the region on the surface layer side. Therefore, the heat dissipation in the plane direction of the resin molded article can be further enhanced.

The average orientation angle (A), the average orientation angle (B), and the ratio M/N described above can be adjusted by using a mixture obtained by dry-blending a resin composition (A) and a resin composition (B) described below.

The average orientation angle (A), the average orientation angle (B), and the ratio M/N can be adjusted by the aspect ratio and content of the graphite; the average particle size of the graphite; the length, aspect ratio, and content of the fibrous body; the type, molecular weight, and MFR (Melt Flow Rate) of the resin; the content ratio of the resin, the graphite, and the fibrous body; the presence or absence of the carbon black and the content thereof; and the like.

Hereinafter, details of each material constituting the resin composition of the present invention will be described.

(Thermoplastic resin)

The thermoplastic resin is not particularly limited, and a known thermoplastic resin can be used. Specific examples of the thermoplastic resin include polyolefins, polystyrenes, polyacrylates, polymethacrylates, polyacrylonitriles, polyesters, polyamides, polyurethanes, polyethersulfones, polyetherketones, polyimides, polydimethylsiloxanes, polycarbonates, and copolymers containing at least two of these. These thermoplastic resins may be used alone or in combination of two or more thereof.

Since the average orientation angle (A) and the average orientation angle (B) can also be controlled by controlling the fluidity of the thermoplastic resin during melting, the thermoplastic resin is preferably a resin whose fluidity during melting is easily controlled. Such a thermoplastic resin is preferably polyolefin (olefin-based resin) and polyamide (nylon-based resin), and more preferably polyolefin (olefin-based resin).

The polyolefins are not particularly limited, and a known polyolefin can be used. Specific examples of the polyolefins include a polyethylene which is an ethylene homopolymer, and polyethylene-based resins such as an ethylene-α-olefin copolymer, an ethylene-(meth)acrylic acid copolymer, an ethylene-(meth)acrylic acid ester copolymer, and an ethylene-vinyl acetate copolymer. The polyolefin may be polypropylene which is a propylene homopolymer, a polypropylene-based resin such as a propylene-α-olefin copolymer, polybutene which is a butene homopolymer, or a homopolymer or copolymer of a conjugated diene such as butadiene or isoprene. These polyolefins may be used alone or in combination of two or more thereof. From the viewpoint of further easily controlling the fluidity during melting, the polyolefin is preferably polypropylene (polypropylene-based resin).

The polyolefin (olefin-based resin) preferably contains an ethylene component. The content of the ethylene component is preferably 5 mass% to 40 mass%. When the content of the ethylene component is within the above range, the heat resistance can be further enhanced while the impact resistance of the resin molded article is further enhanced.

The MFR of the thermoplastic resin measured in accordance with JIS K7210 is preferably 10 g/10 min or more and more preferably 30 g/10 min or more, and is preferably 200 g/10 min or less and more preferably 100 g/10 min or less. In this case, the average orientation angle (B) with respect to the plane direction of the graphite in the central region can be further increased. Therefore, the heat dissipation in the plane direction of the entire resin molded article can be further enhanced.

(Graphite)

The graphite is preferably plate-like graphite, and for example, scale-like graphite, flaked graphite, graphene, or the like can be used. From the viewpoint of further enhancing the heat dissipation, the graphite is preferably scale-like graphite. These may be used alone or in combination of two or more thereof. From the viewpoint of further enhancing the flame retardancy, the graphite may be expanded graphite.

The flaked graphite is obtained by peeling treatment of the original graphite, and refers to a graphene sheet laminate thinner than the original graphite. The peeling treatment for forming flaked graphite is not particularly limited, and either a mechanical peeling method using a supercritical fluid or the like or a chemical peeling method using an acid may be used. The number of laminated graphene sheets in the flaked graphite may be any number as long as it is smaller than that of the original graphite, and is preferably 10,000 layers or less, more preferably 5,000 layers or less, and further preferably 2,000 layers or less.

The volume average particle size of the plate-like graphite is preferably 50 um or more, more preferably more than 50 um, further preferably 100 um or more, still more preferably 150 um or more, particularly preferably 200 um or more, and most preferably 250 um or more, and is preferably 500 um or less and more preferably 350 um or less. When the volume average particle size of the plate-like graphite is the lower limit value or more or more than the lower limit value, the plate-like graphite can be more easily affected by the flow of the thermoplastic resin, and the average orientation angle (B) with respect to the plane direction of the graphite in the central region can be further increased. Therefore, the heat dissipation in the plane direction of the entire resin molded article can be further enhanced. On the other hand, when the volume average particle size of the plate-like graphite is the upper limit value or less, the flame retardancy of the resin molded article can be further enhanced. In the present invention, two or more kinds of plate-like graphite having different volume average particle sizes may be used in combination.

In the present invention, the volume average particle size refers to a value calculated in accordance with JIS Z 8825:2013 in terms of volume-based distribution by a laser diffraction method using a laser diffraction/scattering type particle size distribution measuring apparatus.

When the volume average particle size is measured, for example, plate-like graphite is put into a soap aqueous solution (neutral detergent: 0.01% contained) so as to have a concentration of 2 wt%, and is irradiated with ultrasonic waves at a power of 300 W for 1 minute using an ultrasonic homogenizer to obtain a suspension. The volume particle size distribution of the plate-like graphite is measured for the suspension by a laser diffraction/scattering type particle size distribution measuring apparatus (product name "Microtrac MT3300" manufactured by NIKKISO CO., LTD.). A cumulative value of 50% of the volume particle size distribution can be calculated as the volume average particle size of the plate-like graphite.

The content of the plate-like graphite is preferably 50 parts by weight or more, more preferably 70 parts by weight or more, further preferably 100 parts by weight or more, particularly preferably more than 100 parts by weight, and most preferably 120 parts by weight or more, and is preferably 300 parts by weight or less, more preferably 250 parts by weight or less, and further preferably 200 parts by weight or less, with respect to 100 parts by weight of the thermoplastic resin. When the content of the plate-like graphite is the lower limit value or more or more than the lower limit value, the heat dissipation can be further enhanced. When the content of the plate-like graphite is too large, the area of the interface serving as a starting point of the fracture increases, and thus when the content of the plate-like graphite is the upper limit value or less, the impact resistance can be further enhanced.

The aspect ratio of the plate-like graphite is preferably 5 or more and more preferably 21 or more, and is preferably 2,000 or less, more preferably 1,000 or less, and further preferably 100 or less. When the aspect ratio of the plate-like graphite is the lower limit value or more, the heat dissipation in a plane direction can be further enhanced. When the aspect ratio of the plate-like graphite is the upper limit value or less, for example, the graphite particles themselves are hardly bent in the thermoplastic resin during injection molding. Therefore, the thermal conductivity in the in-plane direction can be further enhanced. In the present specification, the aspect ratio refers to a ratio of the maximum dimension of the plate-like graphite in a stacking plane direction to the thickness of the plate-like graphite.

The shape and thickness of the plate-like graphite can be measured using, for example, a transmission electron microscope (TEM) or a scanning electron microscope (SEM). From the viewpoint of further facilitating the observation, it is desirable to perform the observation with a transmission electron microscope (TEM) or a scanning electron microscope (SEM) after heating a test piece cut out from the resin composition or the resin molded article at 600°C to evaporate the resin. The test piece may be cut out along a direction along the main surface of the resin molded article or may be cut out along a direction orthogonal to the main surface of the resin molded article as long as the thickness of the plate-like graphite can be measured by evaporating the resin.

(Fibrous body)

As the fibrous body, for example, glass fibers, carbon fibers, resin fibers such as cellulose fibers and aramid fibers, metal fibers, or the like can be used. These may be used alone or in combination of two or more thereof. Among them, the fibrous body is preferably glass fiber, carbon fiber, or resin fiber, and more preferably glass fiber.

The carbon fibers are not particularly limited, and PAN-based or pitch-based carbon fibers and the like can be used.

The length of the fibrous body is not particularly limited, and is preferably 3 mm or more and more preferably 5 mm or more, and is preferably 20 mm or less and more preferably 15 mm or less. When the length of the fibrous body is within the above range, the heat dissipation of the resulting resin molded article can be further enhanced.

The fiber diameter of the fibrous body is preferably 5 um or more and more preferably 10 um or more, and is preferably 50 um or less and more preferably 30 um or less. When the fiber diameter of the fibrous body is within the above range, the heat dissipation of the resulting resin molded article can be further enhanced.

The length and the fiber diameter of the fibrous body can be, for example, average values of 100 fibers measured using a transmission electron microscope (TEM) or a scanning electron microscope (SEM). From the viewpoint of further facilitating the observation, it is desirable to perform the observation with a transmission electron microscope (TEM) or a scanning electron microscope (SEM) after heating a test piece cut out from the resin composition or the resin molded article at 600°C to evaporate the resin.

The content of the fibrous body is not particularly limited, and is preferably 10 parts by weight or more and more preferably 20 parts by weight or more, and is preferably 200 parts by weight or less and more preferably 100 parts by weight or less, with respect to 100 parts by weight of thermoplastic resin. When the content of the fibrous body is within the above range, the heat dissipation of the resulting resin molded article can be further enhanced.

(Carbon black)

The resin composition of the present invention may further contain carbon black. As the carbon black, for example, oil furnace black such as Ketjen black, acetylene black, channel black, thermal black, and the like can be used. Among these, from the viewpoint of further enhancing the conductivity of a resulting resin molded article, oil furnace black is preferable. The carbon black may contain metal impurities such as Fe and Ni. One kind of carbon black may be used alone, or two or more kinds thereof may be used in combination.

The DBP oil absorption amount of the carbon black is not particularly limited, and is preferably 160 ml/100 g or more and more preferably 200 ml/100 g or more, and is preferably 800 ml/100 g or less, more preferably 500 ml/100 g or less, and further preferably 400 ml/100 g or less. When the DBP oil absorption amount of the carbon black is the lower limit value or more, the conductivity and the flame retardancy of the resulting resin molded article can be further enhanced. When the DBP oil absorption amount of the carbon black is the upper limit value or less, aggregation at the time of kneading can be prevented and stability can be further improved.

The DBP oil absorption amount of the carbon black can be measured in accordance with JIS K 6217-4. The DBP oil absorption amount can be measured using, for example, an absorption amount measuring instrument (Product No. "S-500" manufactured by Asahi Souken Co., Ltd.).

The content of the carbon black is preferably 10 parts by weight or more, more preferably 15 parts by weight or more, and further preferably 20 parts by weight or more, and is preferably 100 parts by weight or less, more preferably 80 parts by weight or less, and further preferably 50 parts by weight or less, with respect to 100 parts by weight of the thermoplastic resin. When the content of the carbon black is the lower limit value or more, the conductivity and the flame retardancy can be further enhanced. The heat dissipation in the plane direction of the resin molded article can be further enhanced. On the other hand, when the content of the carbon black is the upper limit value or less, the balance among the conductivity, the flame retardancy, and the impact resistance can be further enhanced.

The primary particle size of the carbon black is preferably 35 nm or more, and is preferably 50 nm or less and more preferably 45 nm or less. When the primary particle size of the carbon black is within the above range, higher conductivity and higher flame retardancy can be obtained at a lower concentration of the carbon black content.

The primary particle size of the carbon black is, for example, an average primary particle size obtained using image data of the carbon black obtained by a transmission electron microscope (TEM). As the transmission electron microscope, for example, product name "JEM-2200FS" manufactured by JEOL Ltd. can be used.

(Other additives)

Various other additives may be added as optional components to the resin composition of the present invention as long as the effects of the present invention are not impaired. Examples of the additives include antioxidants such as phenol-based, phosphorus-based, amine-based, and sulfur-based antioxidants; ultraviolet absorbers such as benzotriazole-based and hydroxyphenyltriazine-based ultraviolet absorbers; a metal inhibitor; various fillers; an antistatic agent; a stabilizer; and a pigment. These may be used alone or in combination of two or more thereof.

(Resin composition)

The resin composition of the present invention is preferably a mixture obtained by dry-blending the resin composition (A) and the resin composition (B). In this case, a mixture obtained by dry-blending 50 wt% or more and 99 wt% or less of the resin composition (A) and 1 wt% or more and 50 wt% or less of the following resin composition (B) is preferable.

The resin composition (A) preferably contains 10 wt% or more and 70 wt% or less of a thermoplastic resin (a) and 30 wt% or more and 90 wt% or less of graphite. The content of the thermoplastic resin (a) and the plate-like graphite is a content when the entire resin composition (A) is regarded as 100 wt%. The content of the thermoplastic resin (a) is preferably 20 wt% or more and preferably 60 wt% or less when the entire resin composition (A) is regarded as 100 wt%. The content of the plate-like graphite is preferably 40 wt% or more and preferably 80 wt% or less when the entire resin composition (A) is regarded as 100 wt%.

The resin composition (A) is preferably a compound obtained by melt-kneading 10 wt% or more and 70 wt% or less of the thermoplastic resin (a) and 30 wt% or more and 90 wt% or less of the graphite. The melt-kneading method is not particularly limited, and examples thereof include a method in which kneading is performed under heating using a kneading apparatus such as twin-screw kneader such as a plastomill, a single-screw extruder, a twin-screw extruder, a Banbury mixer, a roll, or a pressurizing kneader. Among them, a method of melt-kneading using an extruder is preferable. The form of the resin composition (A) is not particularly limited, and can be, for example, a pellet.

In the case of a pellet, the shape thereof is not particularly limited, and examples thereof include a spherical shape, a cylindrical shape, and a prismatic shape. Among them, from the viewpoint of the stability of the pellet shape, a cylindrical shape is preferable. Regarding the size of the pellet, when the shape of the pellet is, for example, cylindrical, the diameter thereof is preferably 0.5 mm or more and more preferably 1 mm or more, and is preferably 5 mm or less and more preferably 3 mm or less. The length thereof is preferably 1 mm or more and more preferably 3 mm or more, and is preferably 10 mm or less and more preferably 7 mm or less. The size of the pellet can be measured by randomly collecting 100 pellets from a sample and using a caliper.

The diameter of the pellet (pellet diameter) of the resin composition (A) other than the cylindrical shape is preferably 1 mm or more and more preferably 3 mm or more, and is preferably 10 mm or less and more preferably 8 mm or less. The pellet diameter can be determined by randomly collecting 100 pellets from a sample and measuring the diameter at the longest point using a caliper.

As the thermoplastic resin (a), the above-described thermoplastic resin can be appropriately used. Also as the graphite, the above-described graphite can be appropriately used. The thermoplastic resin (a) may contain other materials such as the above-described carbon black and other additives as necessary.

The resin composition (B) preferably contains 10 wt% or more and 70 wt% or less of a thermoplastic resin (b) and 30 wt% or more and 90 wt% or less of a fibrous body having a length of 1 mm or more. The content of the thermoplastic resin (b) and the fibrous body is a content when the entire resin composition (B) is regarded as 100 wt%. The content of the thermoplastic resin (b) is preferably 20 wt% or more and more preferably 30 wt% or more when the entire resin composition (B) is regarded as 100 wt%. The content of the fiber is preferably 80 wt% or less and more preferably 70 wt% or less when the entire resin composition (B) is regarded as 100 wt%.

The resin composition (B) is preferably a compound obtained by impregnating fibers with the molten thermoplastic resin (b). In particular, the resin composition (B) is more desirably a compound produced by a pultrusion method in which continuous fibers are impregnated with the thermoplastic resin (b), continuously solidified in a mold, and then continuously pulled out with a tensile machine. In this case, the heat dissipation in the resulting resin molded article can be further enhanced. The form of the resin composition (B) is not particularly limited, and can be, for example, a pellet.

In the case of a pellet, the shape thereof is not particularly limited, and examples thereof include a spherical shape, a cylindrical shape, and a prismatic shape. Among them, from the viewpoint of the stability of the pellet shape, a cylindrical shape is preferable. Regarding the size of the pellet, when the shape of the pellet is, for example, cylindrical, the diameter thereof is preferably 0.5 mm or more and more preferably 1 mm or more, and is preferably 5 mm or less and more preferably 3 mm or less. The length thereof is preferably 1 mm or more and more preferably 3 mm or more, and is preferably 10 mm or less and more preferably 7 mm or less. The size of the pellet can be measured by randomly collecting 100 pellets from a sample and using a caliper.

The diameter of the pellet (pellet diameter) of the resin composition (B) other than the cylindrical shape is preferably 1 mm or more and more preferably 5 mm or more, and is preferably 15 mm or less and more preferably 10 mm or less. The pellet diameter can be determined by randomly collecting 100 pellets from a sample and measuring the diameter at the longest point using a caliper.

As the thermoplastic resin (b), the above-described thermoplastic resin can be appropriately used. Also as the fibrous body, the above-described fibrous body can be appropriately used. The thermoplastic resin (b) may contain other materials such as the carbon black and other additives as necessary.

In the resin composition (B), the fibrous body is preferably oriented. Among them, uniaxial orientation is preferable. Such a resin composition (B) can be produced by aligning fibers and bringing the fibers into contact with a molten thermoplastic resin (b). In particular, in the case of production by a pultrusion method, a resin composition (B) in which the fiber is impregnated with the thermoplastic resin (b) can be obtained.

In the present specification, dry blending means mixing without applying external force due to shearing or the like to change the pellet shape or pulverize the pellet without melting or addition of a solvent. Such a dry blending method is not particularly limited, and can be performed, for example, by simply mixing the resin composition (A) and the resin composition (B) with a hand. Mixing may be performed using a small tumbler or the like.

[Resin molded article]

A resin molded article of the present invention is a molded article of the above-described resin composition of the present invention.

The method for molding the resin composition is not particularly limited, and examples thereof include methods such as press working, extrusion processing, extrusion lamination processing, and injection molding. Among them, it is preferable to mold the mixture by injection molding. In this case, the heat dissipation and the mechanical strength of the resulting resin molded article can be further enhanced.

Since the resin molded article of the present invention is a molded article of the above-described resin composition of the present invention, the heat dissipation can be enhanced.

Whether or not the resin molded article is a molded article of the resin composition of the present invention can be determined by once melting the resin molded article, preparing a resin molded article again according to the above-described condition (1), measuring the average orientation angle (A) and the average orientation angle (B), and determining whether or not the average orientation angle (A) and the average orientation angle (B) fall within the specific ranges of the present invention.

The thermal conductivity in the in-plane direction of the main surface of the resin molded article is preferably 5 W/(m·K) or more, more preferably 10 W/(m·K) or more, further preferably 16 W/(m·K) or more, particularly preferably 20 W/(m·K) or more, and most preferably 25 W/ (m·K) or more. In this case, the heat dissipation of the resin molded article can be further enhanced. The upper limit value of the thermal conductivity in the in-plane direction is not particularly limited, and can be, for example, 50 W/(m·K). The thermal conductivity is a thermal conductivity when the resin composition in a molten state is filled in a mold from a direction orthogonal to a thickness direction of a resulting resin molded article and molded to obtain a resin molded article of 100 mm in length × 100 mm in width × 2 mm in thickness.

The main surface may be a flat surface or a curved surface. In the present invention, the main surface is a surface having the largest area among a plurality of surfaces on the outer surface of the resin molded article, and refers to a continuous surface.

The thermal conductivity in the in-plane direction can be calculated using the following Formula (1).

$$\text{Thermal conductivity } (W/(m \cdot K)) = \text{Specific gravity } (g/cm^3) \times$$

$$\text{Specific heat } (J/g \cdot K) \times \text{Thermal diffusivity } (mm^2/s) \ldots \quad \text{Formula}$$

$$(1)$$

The thermal diffusivity can be measured using, for example, Product No. "Xenon Flash Laser Analyzer LFA 467 HyperFlash" manufactured by NETZSCH Japan K.K.

In the resin molded article, it is preferable that a thermal conductivity $\lambda x$ in an x direction, a thermal conductivity $\lambda y$ in a y direction, and a thermal conductivity $\lambda z$ in a z direction satisfy $\min(\lambda x, \lambda y)/\lambda z \geq 4$.

The x direction is any direction along the main surface. The y direction is a direction along the main surface and orthogonal to the x direction. The z direction is the thickness direction of the resin molded article. The thickness direction of the resin molded article is a direction orthogonal to the main surface. Therefore, the z direction is a direction orthogonal to the x direction and the y direction. The main surface may be a flat surface or a curved surface.

The thermal conductivity in each of the x direction, the y direction, and the z direction can be calculated using the above Formula (1).

The $\min(\lambda x, \lambda y)$ means the lower value of the thermal conductivity between $\lambda x$ and $\lambda y$. Therefore, "$\min(\lambda x, \lambda y)/\lambda z \geq 4$" means that a ratio of the lower thermal conductivity between $\lambda x$ and $\lambda y$ to $\lambda z$ is 4 or more.

When $\min(\lambda x, \lambda y)/\lambda z \geq 4$ is satisfied, the thermal conductivity in the plane direction is higher than the thermal conductivity in the thickness direction. Therefore, in this case, the heat dissipation in the plane direction of the resin molded article can be further enhanced. The upper limit value of $\min(\lambda x, \lambda y)/\lambda z$ is not particularly limited, and can be, for example, 8.

The resin molded article of the present invention is excellent in heat dissipation. Therefore, the resin molded article can be suitably used for, for example, a casing of a communication device or an electronic device, such as a security camera or a smart meter, to be used indoors or outdoors. Alternatively, the resin molded article can be suitably used for a heat dissipation chassis of multi-information display, such as a car navigation system or a smart meter, or an in-vehicle camera, a heat sink such as an LED heat dissipation heat sink, or a heat dissipation plate of SoC, GDC, or the like.

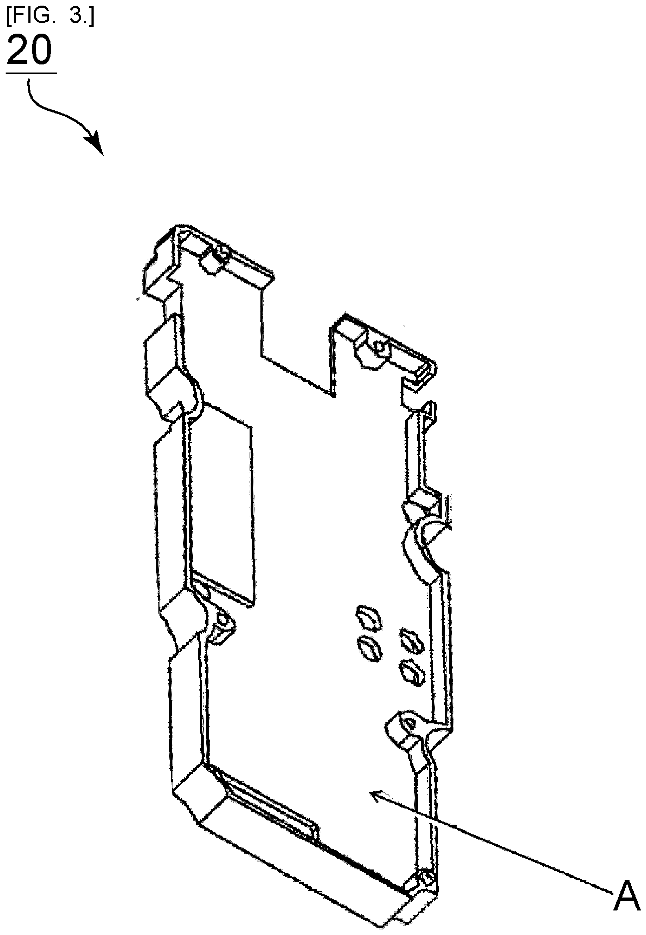

The resin molded article obtained in the present invention is preferably a heat dissipation chassis, a heat dissipation casing, or a heat sink shape. Hereinafter, specific examples of a heat dissipation chassis, a heat dissipation casing, and a heat sink shape will be described with reference to Figs. 3 to 5.

Fig. 3 is a schematic view of a heat dissipation chassis. When the resin molded article is a heat dissipation chassis 20, a portion indicated by arrow A in Fig. 3 is a main surface.

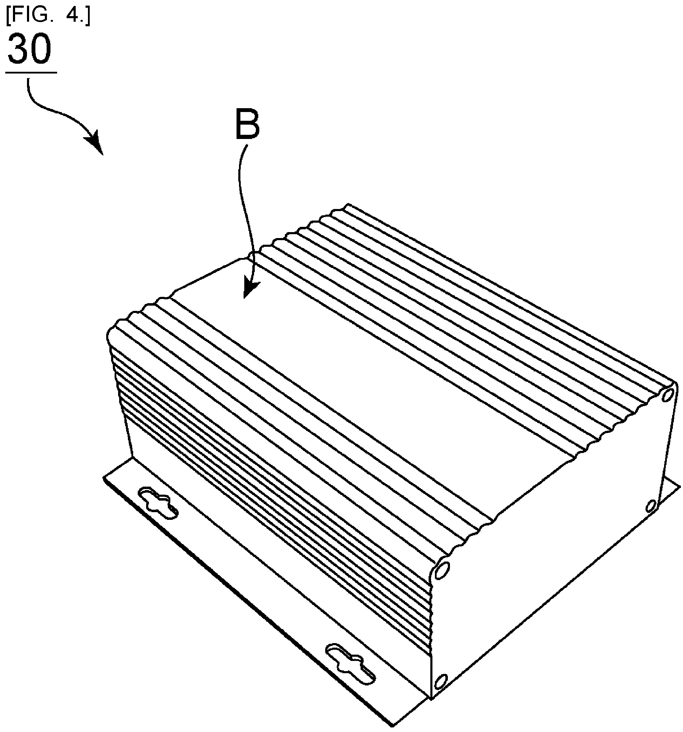

Fig. 4 is a schematic view of a heat dissipation casing. When the resin molded article is a heat dissipation casing 30, a portion indicated by arrow B in Fig. 4 is a main surface. As illustrated in Figs. 3 and 4, the main surface may have irregularities.

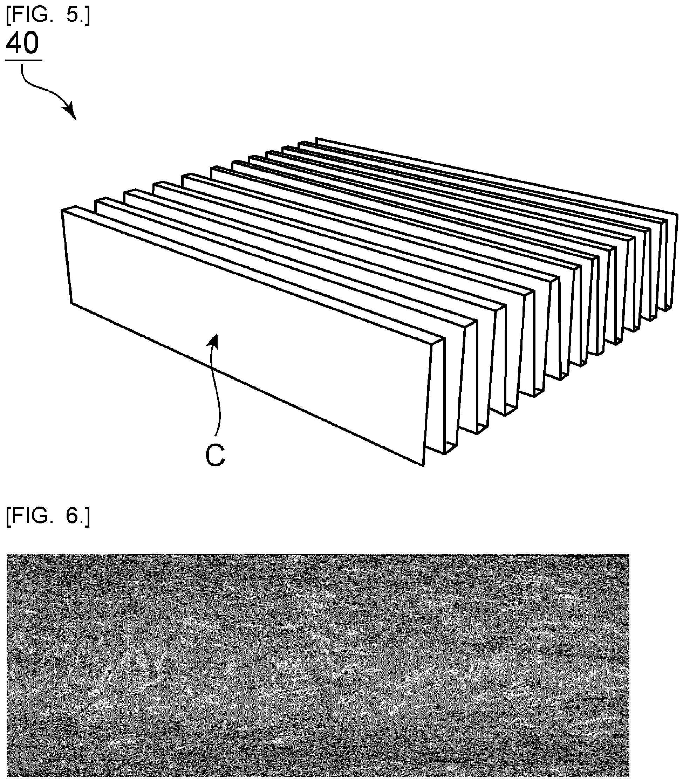

Fig. 5 is a schematic view of a heat sink shape. When the resin molded article is a heat sink shape 40, a portion indicated by arrow C in Fig. 5 is a main surface. Specifically, the main surface on one side of a bottom plate portion and the surface of a fin portion are the main surfaces. In this manner, a plurality of main surfaces may be present.

A circuit may be formed on the surface of such a resin molded article.

Hereinafter, the effects of the present invention will be clarified with reference to specific Examples and Comparative Examples of the present invention. The present invention is not limited to the following Examples.

(Example 1)

Production of resin composition (A-1);

Polypropylene (PP) (30 wt%) as the thermoplastic resin (a) and scale-like graphite (70 wt%) as plate-like graphite were melt-kneaded at 200°C using Labo Plastomill (Product No. "R100" manufactured by Toyo Seiki Seisaku-sho, Ltd.) to obtain a resin composition (A-1). The obtained resin composition (A-1) had a pellet shape and a pellet diameter of 5 mm. The pellet diameter was determined by randomly collecting 100 pellets from a sample and measuring the diameter at the longest point using a caliper. As the polypropylene, trade name "MA04A" (MFR: 40 g/10 min (230°C)) manufactured by Japan Polypropylene Corporation was used. As the scale-like graphite, trade name "CPB-300" (average particle size: 300 um, aspect ratio: 10) manufactured by Chuetsu Graphite Works Co., Ltd. was used.

Production of resin composition (B-1);

A resin composition (B-1) was obtained according to a pultrusion method by using 40 wt% of polypropylene (PP) as the thermoplastic resin (b) and 60 wt% of glass fibers having a length of 7 mm. The obtained resin composition (B-1) had a pellet shape and a pellet diameter of 7 mm. As the polypropylene, trade name "MA04A" (MFR: 40 g/10 min (230°C)) manufactured by Japan Polypropylene Corporation was used. As roving fibers, trade name "TUFROV 4520" (fiber diameter: 16 um) manufactured by Nippon Electric Glass Co., Ltd. was used.

The obtained resin composition (A-1) and resin composition (B-1) were dry-blended at a rotation speed of 30 rpm for 5 minutes using a small tumbler at a ratio of 17 : 3 to obtain a resin composition.

(Example 2)

Production of resin composition (A-2);

Polypropylene (PP) (40 wt%) as the thermoplastic resin and scale-like graphite (60 wt%) as plate-like graphite were melt-kneaded at 200°C using Labo Plastomill (Product No. "R100" manufactured by Toyo Seiki Seisaku-sho, Ltd.) to obtain a resin composition (A-2). The obtained resin composition (A-2) had a pellet shape and a pellet diameter of 5 mm. The pellet diameter was determined by randomly collecting 100 pellets from a sample and measuring the diameter at the longest point using a caliper. As the polypropylene, trade name "MA04A" (MFR: 40 g/10 min (230°C)) manufactured by Japan Polypropylene Corporation was used. As the scale-like graphite, trade name "CRC-80N" (average particle size: 300 um, aspect ratio: 10) manufactured by Fuji Graphite Works Co., Ltd. was used.

The obtained resin composition (A-2) and resin composition (B-1) were dry-blended at a rotation speed of 30 rpm for 5 minutes using a small tumbler at a ratio of 19 : 1 to obtain a resin composition.

(Example 3)

Production of resin composition (A-3);

Polypropylene (PP) (30 wt%) as the thermoplastic resin (a) and scale-like graphite (70 wt%) as plate-like graphite were melt-kneaded at 200°C using Labo Plastomill (Product No. "R100" manufactured by Toyo Seiki Seisaku-sho, Ltd.) to obtain a resin composition (A-3). The obtained resin composition (A-3) had a pellet shape and a pellet diameter of 5 mm. The pellet diameter was determined by randomly collecting 100 pellets from a sample and measuring the diameter at the longest point using a caliper. As the polypropylene, trade name "MA04A" (MFR: 40 g/10 min (230°C)) manufactured by Japan Polypropylene Corporation was used. As the scale-like graphite, trade name "CPB-100B" (average particle size: 80 um, aspect ratio: 4) manufactured by Chuetsu Graphite Works Co., Ltd. was used.

The obtained resin composition (A-3) and resin composition (B-1) were dry-blended at a rotation speed of 30 rpm for 5 minutes using a small tumbler at a ratio of 17 : 3 to obtain a resin composition.

(Comparative Example 1)

Production of resin composition (B-2);

A resin composition (B-2) was obtained in the same manner as in the resin composition (B-1), except that glass fibers were not used.

The resin composition (A-2) and the resin composition (B-2) were dry-blended at a rotation speed of 30 rpm for 5 minutes using a small tumbler at a ratio of 17 : 3 to obtain a resin composition.

(Comparative Example 2)

Production of resin composition (A-5);

A resin composition (A-5) was obtained in the same manner as in the resin composition (A-2), except that the ratio of the polypropylene (PP) was set to 65 wt% and the ratio of the scale-like graphite was set to 35 wt%.

A resin composition was obtained in the same manner as in Example 2, except that the resin composition (A-5) prepared as described above was used instead of the resin composition (A-2).

(Comparative Example 3)

A resin composition was obtained in the same manner as in Example 3, except that the resin composition (B-2) was used instead of the resin composition (B-1).

(Evaluation)

<Average orientation angle>

The resin composition obtained in each of Examples 1 and 2 and Comparative Examples 1 and 2 was injection-molded using a side gate mold having a gate width of 8 mm and a gate thickness of 1.5 mm to obtain a resin molded article of 100 mm in length × 100 mm in width × 2 mm in thickness. Injection molding was performed under conditions of a resin temperature of 230°C, a mold temperature of 50°C, and an injection speed of 30 mm/s. The resin composition in a molten state was filled in a mold from a direction orthogonal to the thickness direction of a resulting resin molded article and molded.

As illustrated in Fig. 1(b), the obtained resin molded article was cut with scissors along a direction (X direction) parallel to the filling direction and the thickness direction (Z direction) and treated with an ultrasonic cutting device to obtain a cross-section. The obtained cross-section was observed with a microscope (Product No. "VHX-5000" manufactured by KEYENCE CORPORATION) at a magnification of 200 times to obtain images, and the images were connected by 4 sheets in the longitudinal direction × 5 sheets in the lateral direction to obtain a cross-sectional photograph.

Fig. 6 is a cross-sectional photograph of a resin molded article obtained in Example 1. As shown in Fig. 6, in the resin molded article obtained in Example 1, it is found that the graphite is more oriented in the plane direction on the outermost layer side, whereas the graphite is also oriented in the thickness direction on the center side.

For the cross-sectional photograph obtained as described above, the average orientation angle was determined using OrientationJ that is a plug-in for image analysis software ImageJ (manufactured by National Institute of Health; NIH). Specifically, the direction was calculated from the slope of the luminance value of each pixel in the obtained cross-sectional photograph. The calculated direction (angle formed with the horizontal axis) was stored as a pixel value instead of the luminance value. This operation was performed on all the pixels to obtain an orientation map in which the direction calculated from the slope of the luminance value was used as the pixel value. The values of respective pixels of the obtained orientation map were aggregated to create a histogram, and a weighted average was calculated to obtain an average orientation angle of each layer. The average orientation angle was determined for each of regions obtained by dividing the cross-sectional photograph into five equal parts in the thickness direction. As illustrated in Fig. 2, the average orientation angle was also determined for a cross-section obtained by cutting the resin molded article along a direction (Y direction) orthogonal to the filling direction and the thickness direction (Z direction) by the same method.

The image analysis conditions of OrientationJ are as follows.

1. Local window (tensor) = 5.0
2. Method of binarization:Huang dark method

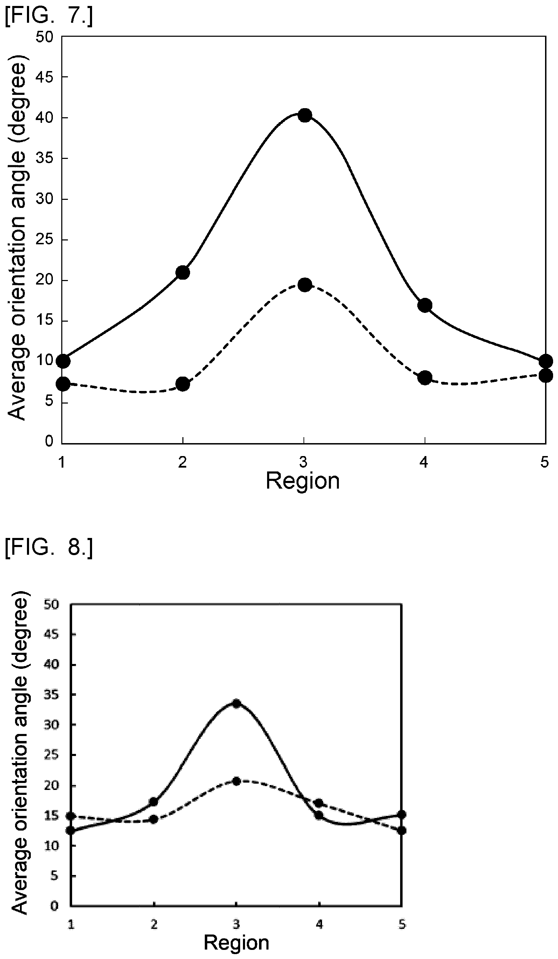

Fig. 7 is a view showing an average orientation angle of each region in a cross-section of the resin molded article obtained in Example 1. In the drawing, the regions obtained by dividing the cross-sectional photograph into five equal parts in the thickness direction are shown as 1 to 5 in order from the top. The regions on outermost layer sides are indicated as "1" and "5", and the central region is indicated as "3". A solid line is a result of the cross-section obtained by cutting the resin molded article along the direction (X direction) parallel to the filling direction and the thickness direction (Z direction), and a broken line is a result of the cross-section obtained by cutting the resin molded article along the direction (Y direction) orthogonal to the filling direction and the thickness direction (Z direction). From Fig. 7, in the cross-section obtained by cutting the resin molded article along the direction (X direction) parallel to the filling direction and the thickness direction (Z direction), the average orientation angle (A) on the outermost layer side (1) was 10°, the average orientation angle (B) on the center side (3) was 40°, and the ratio (average orientation angle (B)/average orientation angle (A)) was 4.0. In the cross-section obtained by cutting the resin molded article along the direction (Y direction) orthogonal to the filling direction and the thickness direction (Z direction), the average orientation angle (A) on the outermost layer side (1) was 7°, the average orientation angle (B) on the center side (3) was 20°, and the ratio (average orientation angle (B)/average orientation angle (A)) was 2.86.

Fig. 8 is a view showing an average orientation angle of each region in a cross-section of a resin molded article obtained in Comparative Example 1. In the drawing, the regions obtained by dividing the cross-sectional photograph into five equal parts in the thickness direction are shown as 1 to 5 in order from the top. The regions on outermost layer sides are indicated as "1" and "5", and the central region is indicated as "3". A solid line is a result of the cross-section obtained by cutting the resin molded article along the direction (X direction) parallel to the filling direction and the thickness direction (Z direction), and a broken line is a result of the cross-section obtained by cutting the resin molded article along the direction (Y direction) orthogonal to the filling direction and the thickness direction (Z direction). From Fig. 8, in the cross-section obtained by cutting the resin molded article along the direction (X direction) parallel to the filling direction and the thickness direction (Z direction), the average orientation angle (A) on the outermost layer side (1) was 12°, the average orientation angle (B) on the center side (3) was 33°, and the ratio (average orientation angle (B)/average orientation angle (A)) was 2.8. In the cross-section obtained by cutting the resin molded article along the direction (Y direction) orthogonal to the filling direction and the thickness direction (Z direction), the average orientation angle (A) on the outermost layer side (1) was 12°, the average orientation angle (B) on the center side (3) was 21°, and the ratio (average orientation angle (B)/average orientation angle (A)) was 1.8.

<Thermal conductivity (W/(m·K))>

The resin composition obtained in each of Examples 1 to 3 and Comparative Examples 1 to 3 was injection-molded to obtain a resin molded article of 100 mm in length × 100 mm in width × 2 mm in thickness. The central portion of the obtained resin molded article was punched into a size of 10 mm in length × 2 mm in width × 2 mm in thickness to prepare a measurement sample. Injection molding was performed under conditions of a resin temperature of 230°C, a mold temperature of 50°C, and an injection speed of 30 mm/s.

The thermal conductivity (thermal conductivity in the in-plane direction and the thickness direction) of the obtained measurement sample was measured using Product No. "Xenon Flash Laser Analyzer LFA 467 HyperFlash" manufactured by NETZSCH Japan K.K. Specifically, the measurement sample was fitted into a holder in a direction in which the thermal conductivity can be measured, the thermal diffusivity at 30°C was measured, and the thermal conductivity was calculated according to the following Formula (1).

$$\text{Thermal conductivity } (W/(m \cdot K)) = \text{Specific gravity } (g/cm^3) \times \text{Specific heat } (J/g \cdot K) \times \text{Thermal diffusivity } (mm^2/s) ... \quad \text{Formula} \quad (1)$$

<Raman spectroscopic analysis>

The resin composition obtained in each of Examples 1 and 3 and Comparative Examples 2 and 3 was injection-molded to obtain a resin molded article of 100 mm in length × 100 mm in width × 2 mm in thickness. Injection molding was performed under conditions of a resin temperature of 230°C, a mold temperature of 50°C, and an injection speed of 30 mm/s. The resin composition in a molten state was filled in a mold from a direction orthogonal to the thickness direction of a resulting resin molded article and molded.

The obtained resin molded article was cut along the thickness direction with an ultrasonic cutting device to obtain a cross-section. In the obtained cross-section, the surface layer portion and the cross-sectional center portion of the resin molded article were subjected to Raman spectroscopic analysis.

The Raman spectroscopic analysis of the resin molded article was measured under the following measurement conditions using a Raman spectrometer (trade name "inVia Qontor" manufactured by Renishaw plc) .

<Measurement conditions>

Objective lens: magnification 50 times
Excitation laser wavelength: 532 nm
Laser power: 0.5%
Irradiation time: 5 seconds
Diffraction grating: 1,800 lines/mm
Measurement wavenumber: 605cm$^{-1}$ to 2281cm$^{-1}$

The D/G ratios of the surface layer portion and the cross-sectional center portion of the resin molded article were determined by defining the maximum peak intensity in a range of 1,300 cm$^{-1}$ to 1,400 cm$^{-1}$ of the obtained Raman spectrum as the peak intensity of the D band and defining the maximum peak intensity in a range of 1,550 cm$^{-1}$ to 1,620 cm$^{-1}$ as the peak intensity of the G band.

The ratio M/N was determined where a peak intensity ratio (D/G ratio) of a surface layer portion of the resin molded article was designated as "M", and a peak intensity ratio (D/G ratio) between a D band and a G band obtained when a cross-sectional center portion of the resin molded article was subjected to Raman spectroscopic analysis was defined as "N". The measurement and analysis were performed according to the method described in the section of the fifth invention.

Results are shown in Table 1.

[Table 1]

| | Cross-section in X direction and Z direction | | | Cross-section in Y direction and Z direction | | | Thermal conductivity (W/(m·K)) | | Raman spectroscopic analysis | | |
|---|---|---|---|---|---|---|---|---|---|---|---|
| | Average orientation angle (A) on outermost layer side (1) | Average orientation angle (B) on center side (3) | Ratio (average orientation angle (B)/ average orientation angle (A)) | Average orientation angle (A) on outermost layer side (1) | Average orientation angle (B) on center side (3) | Ratio (average orientation angle (B)/ average orientation angle (A)) | In-plane direction | Thickness direction | Cross-sectional surface layer portion D/G ratio (M) | Cross-sectional center portion D/G ratio (N) | Ratio M/N |
| Example 1 | 10° | 40° | 4.0 | 7° | 20° | 2.9 | 17.3 | 3.1 | 1.12 | 1.10 | 1.02 |
| Example 2 | 9° | 36° | 4.0 | 8° | 17° | 2.1 | 12.9 | 2.8 | - | - | - |
| Example 3 | - | - | - | - | - | - | 13.8 | 2.8 | 0.18 | 0.58 | 0.31 |
| Comparative Example 1 | 12° | 33° | 2.8 | 12° | 21° | 1.8 | 8.5 | 1.9 | - | - | - |
| Comparative Example 2 | 11° | 23° | 2.1 | 12° | 19° | 1.6 | 3.6 | 1.1 | 0.17 | 0.59 | 0.29 |
| Comparative Example 3 | - | - | - | - | - | - | 9.7 | 1.9 | 0.16 | 0.57 | 0.28 |

**EXPLANATION OF SYMBOLS**

1: Resin molded article
1A to 1E, 2A to 2E: Region
20: Heat dissipation chassis
30: Heat dissipation casing
40: Heat sink shape

**Claims**

1. A resin composition comprising:

   a thermoplastic resin;
   graphite; and
   a fibrous body,
   when the resin composition in a molten state is filled in a mold from a direction orthogonal to a thickness direction of a resulting resin molded article and molded to obtain a resin molded article of 100 mm in length × 100 mm in width × 2 mm in thickness,
   in a cross-section obtained by cutting the resin molded article along a direction parallel to a filling direction and the thickness direction, among regions obtained by dividing the cross-section into five equal parts in the thickness direction, an average orientation angle (A) with respect to a plane direction of the graphite in at least one of the regions on outermost layer sides being 15° or less, and an average orientation angle (B) with respect to the plane direction of the graphite in the central region being 35° or more.

2. A resin composition comprising:

   a thermoplastic resin;
   graphite; and
   a fibrous body,
   when the resin composition in a molten state is filled in a mold from a direction orthogonal to a thickness direction of a resulting resin molded article and molded to obtain a resin molded article of 100 mm in length × 100 mm in width × 2 mm in thickness,
   in a cross-section obtained by cutting the resin molded article along a direction orthogonal to a filling direction and the thickness direction, among regions obtained by dividing the cross-section into five equal parts in the thickness direction, an average orientation angle (A) with respect to a plane direction of the graphite in at least one of the regions on outermost layer sides being 10° or less, and an average orientation angle (B) with respect to the plane direction of the graphite in the central region being 15° or more.

3. A resin composition comprising:

   a thermoplastic resin;
   graphite; and
   a fibrous body,
   when the resin composition in a molten state is filled in a mold from a direction orthogonal to a thickness direction of a resulting resin molded article and molded to obtain a resin molded article of 100 mm in length × 100 mm in width × 2 mm in thickness,
   in a cross-section obtained by cutting the resin molded article along a direction parallel to a filling direction and the thickness direction, among regions obtained by dividing the cross-section into five equal parts in the thickness direction, a ratio (average orientation angle (B)/average orientation angle (A)) of an average orientation angle (B) with respect to a plane direction of the graphite in the central region to an average orientation angle (A) with respect to the plane direction of the graphite in at least one of the regions on outermost layer sides being 3.5 or more.

4. A resin composition comprising:

a thermoplastic resin;
graphite; and
a fibrous body,
when the resin composition in a molten state is filled in a mold from a direction orthogonal to a thickness direction of a resulting resin molded article and molded to obtain a resin molded article of 100 mm in length × 100 mm in width × 2 mm in thickness,
in a cross-section obtained by cutting the resin molded article along a direction orthogonal to a filling direction and the thickness direction, among regions obtained by dividing the cross-section into five equal parts in the thickness direction, a ratio (average orientation angle (B)/average orientation angle (A)) of an average orientation angle (B) with respect to a plane direction of the graphite in the central region to an average orientation angle (A) with respect to the plane direction of the graphite in at least one of the regions on outermost layer sides being 2 or more.

5. A resin composition comprising:

a thermoplastic resin;
graphite; and
a fibrous body,
when the resin composition in a molten state is filled in a mold from a direction orthogonal to a thickness direction of a resulting resin molded article and molded to obtain a resin molded article of 100 mm in length × 100 mm in width × 2 mm in thickness,
a ratio M/N being 0.30 or more, where a peak intensity ratio (D/G ratio) between a D band and a G band obtained when a surface layer portion of the resin molded article is subjected to Raman spectroscopic analysis is designated as "M", and a peak intensity ratio (D/G ratio) between a D band and a G band obtained when a cross-sectional center portion of a cross-section obtained by cutting the resin molded article along the thickness direction is subjected to Raman spectroscopic analysis is designated as "N".

6. The resin composition according to any one of claims 1 to 5, wherein the graphite is plate-like graphite.

7. The resin composition according to any one of claims 1 to 6, wherein the fibrous body is at least one selected from the group consisting of glass fibers, carbon fibers, and resin fibers.

8. The resin composition according to any one of claims 1 to 7, further comprising carbon black.

9. The resin composition according to any one of claims 1 to 8, wherein the thermoplastic resin includes an olefin-based resin.

10. The resin composition according to any one of claims 1 to 9, wherein when the resin composition in a molten state is filled in a mold from a direction orthogonal to a thickness direction of a resulting resin molded article and molded to obtain a resin molded article of 100 mm in length × 100 mm in width × 2 mm in thickness, a thermal conductivity in an in-plane direction of a main surface of the resin molded article is 2 W/(m·K) or more.

11. A resin molded article being a molded article of the resin composition according to any one of claims 1 to 10.

[FIG. 1.]

(a)

(b)

[FIG. 2.]

[FIG. 3.]

20

A

EP 4 282 610 A1

[FIG. 4.]

<u>30</u>

B

[FIG. 5.]

<u>40</u>

C

[FIG. 6.]

[FIG. 7.]

[FIG. 8.]

## INTERNATIONAL SEARCH REPORT

| International application No. |
|---|
| **PCT/JP2022/002550** |

**A. CLASSIFICATION OF SUBJECT MATTER**

*B29B 15/10*(2006.01)i; *B29C 45/00*(2006.01)i; *B29K 101/12*(2006.01)n; *B29K 105/14*(2006.01)n; *C08J 3/20*(2006.01)i; *C08K 7/02*(2006.01)i; *C08K 7/04*(2006.01)i; *C08L 23/00*(2006.01)i; *C08L 77/00*(2006.01)i; *C08L 101/00*(2006.01)i; *C08J 5/00*(2006.01)i; *B29C 70/06*(2006.01)i; *B29C 70/42*(2006.01)i; *C08K 3/013*(2018.01)i; *C08K 3/04*(2006.01)i
FI:  C08L101/00; C08K3/04; C08K7/04; C08L23/00; B29C45/00; B29B15/10; B29C70/06; B29C70/42; C08L77/00; C08J5/00 CFG; C08K3/013; C08K7/02; C08J3/20 B CER; C08J3/20 CES; B29K105:14; B29K101:12

According to International Patent Classification (IPC) or to both national classification and IPC

**B. FIELDS SEARCHED**

Minimum documentation searched (classification system followed by classification symbols)

B29B15/10; B29C45/00; B29K101/12; B29K105/14; C08J3/20; C08K7/02; C08K7/04; C08L23/00; C08L77/00; C08L101/00; C08J5/00; B29C70/06; B29C70/42; C08K3/013; C08K3/04

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2013-28661 A (UNITIKA LTD.) 07 February 2013 (2013-02-07) claims, paragraphs [0008], [0042], examples | 1-11 |
| X | JP 2020-176243 A (UNITIKA LTD.) 29 October 2020 (2020-10-29) claims, paragraphs [0026], [0030], examples | 1-11 |
| A | JP 2005-108589 A (NICHIAS CORP.) 21 April 2005 (2005-04-21) entire text, all drawings | 1-11 |
| A | WO 2013/133181 A1 (KANEKA CORP.) 12 September 2013 (2013-09-12) entire text, all drawings | 1-11 |
| A | JP 2016-000788 A (AISIN CHEMICAL CO., LTD.) 07 January 2016 (2016-01-07) entire text, all drawings | 1-11 |

☑ Further documents are listed in the continuation of Box C.   ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **16 March 2022** | **05 April 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

# EP 4 282 610 A1

**INTERNATIONAL SEARCH REPORT**

| | International application No. |
|---|---|
| | **PCT/JP2022/002550** |

**C.    DOCUMENTS CONSIDERED TO BE RELEVANT**

| Category* | Citation of document, with indication, where appropriate, of the relevant passages | Relevant to claim No. |
|---|---|---|
| A | WO 2016/035680 A1 (KANEKA CORP.) 10 March 2016 (2016-03-10)<br>entire text, all drawings | 1-11 |
| A | WO 2017/175759 A1 (SEKISUI CHEMICAL CO., LTD.) 12 October 2017 (2017-10-12)<br>entire text, all drawings | 1-11 |
| A | JP 2019-186555 A (SEKISUI POLYMATECH CO., LTD.) 24 October 2019 (2019-10-24)<br>entire text, all drawings | 1-11 |

Form PCT/ISA/210 (second sheet) (January 2015)

**INTERNATIONAL SEARCH REPORT**
Information on patent family members

International application No.

**PCT/JP2022/002550**

| Patent document cited in search report | | | Publication date (day/month/year) | Patent family member(s) | | | Publication date (day/month/year) |
|---|---|---|---|---|---|---|---|
| JP | 2013-28661 | A | 07 February 2013 | (Family: none) | | | |
| JP | 2020-176243 | A | 29 October 2020 | (Family: none) | | | |
| JP | 2005-108589 | A | 21 April 2005 | US entire text, all drawings EP | 2005/0118483 1521320 | A1 A2 | |
| WO | 2013/133181 | A1 | 12 September 2013 | US entire text, all drawings EP CN KR TW | 2015/0014603 2824131 104204041 10-2014-0136967 201343748 | A1 A1 A A A | |
| JP | 2016-000788 | A | 07 January 2016 | (Family: none) | | | |
| WO | 2016/035680 | A1 | 10 March 2016 | US entire text, all drawings EP CN | 2017/0167716 3190636 106605310 | A1 A1 A | |
| WO | 2017/175759 | A1 | 12 October 2017 | CN | 108779267 | A | |
| JP | 2019-186555 | A | 24 October 2019 | US entire text, all drawings EP CN KR | 2020/0243414 3419399 108781524 10-2018-0133842 | A1 A1 A A | |

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012082382 A

- JP 2014000789 A

**Non-patent literature cited in the description**

- **REZAKHANIHA et al.** *Biomechanics and modeling in mechanobiology,* 2012, vol. 11, 461-73

- **NETZSCH JAPAN K.K.** *Xenon Flash Laser Analyzer LFA 467 HyperFlash*